# EUROPEAN PATENT APPLICATION

(11) **EP 2 916 628 A1**
(43) Date of publication of application: **09.09.2015**
(21) Application number: 14158329.4
(22) Date of filing: 07.03.2014
(51) Int. Cl.: H05K 3/28, H01L 33/60, G02B 5/08

(54) **Cover layer with high thermal resistance and high reflectivity for a printed circuit board**

(71) Applicant: Taiflex Scientific Co., Ltd., Kaohsiung (TW)
(72) Inventor: Hung, Tzu-Ching, KAOHSIUNG (TW); Shih, Yu-Chen, KAOHSIUNG (TW); Tien, Feng-Jung, KAOHSIUNG (TW); Lu, Chen-Kuo, KAOHSIUNG (TW); Lee, Yu-Hsien, KAOHSIUNG (TW); Wu, Su-Ping, KAOHSIUNG (TW)
(74) Representative: Geurts, Franciscus Antonius

(57) **Abstract**

A cover layer (10) of a printed circuit board has a polymer film (11), a reflective composite layer (12) and an adhesive layer (13). The polymer film (11) has a melting point greater than 260°C. The reflective composite layer (12) is mounted on one side surface of the polymer film (11) and has a first reflective pigment. The adhesive layer (13) is mounted on another side surface of the polymer film (11). Also, at a range of wavelength where a reflectivity of the cover layer (10) is greater than 89%, absorption of the polymer film (11) to the same range of wavelength is less than 35%. The cover layer (10) is laminated on a printed circuit board and after surface mount technology process at a temperature ranging from 160°C to 320°C, the cover layer (10) has a reflectivity over 89% without yellowing and delamination.

## Description

### 1. Field of the Invention

The present invention relates to a cover layer for a printed circuit board; particularly, to a cover layer with high thermal resistance and high reflectivity for a printed circuit board.

### 2. Description of the Prior Art(s)

Light transmission and light distribution effect of an illumination module of an electronic product are achieved by using secondary optical elements. As light of illumination elements of the illumination module passes through the secondary optical elements, loss of light, such as light absorption and light scattering, may occur, and hence light of the illumination module is not effectively utilized. Also, luminous efficacy and color rendering index of the electronic product is affected. In addition, after light of the illumination elements of the illumination module passes through the secondary optical elements, luminous intensity of illumination elements decays with distance; thus, raising power of illumination elements is required to ensure luminous efficacy of the electronic product. For example, using light guiding plates can achieve a homogenized planar light source effect of a back light module, but light absorption and light scattering of the light guide plate results in light loss.

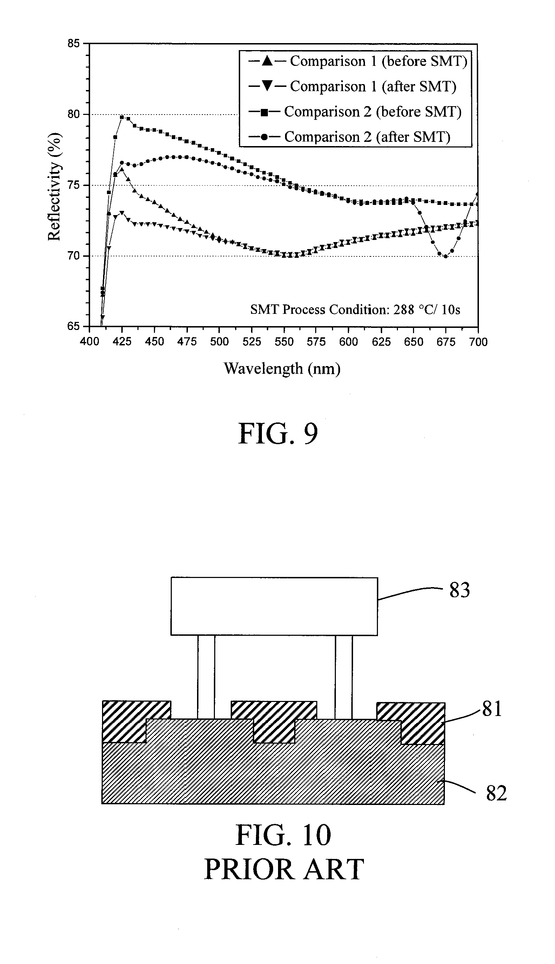

With reference to Fig. 10, to decrease light loss caused by the secondary optical elements, a printed circuit board having a reflective ink is provided for an illumination module of an electronic product. The reflective ink 81 is printed on a surface of the printed circuit board 82. An illumination element 83 of the illumination module is mounted on the surface of the printed circuit board 82 by surface mount technology (SMT). By the reflective ink 81, scattering light of the illumination element 83 forwarding to the surface of the printed circuit board 82 is reflected and leaves the printed circuit board 82, such that luminous efficacy and color rendering of the electronic product are both enhanced.

However, as the illumination element 83 is mounted on printed circuit board 82 under a temperature between 160°C and 320°C, the reflective ink 81 yellows and thereby reflectivity of the reflective ink 81 is decreased. In addition, as thickness of the reflective ink 81 is increased to enhance its reflectivity, the thicker reflective ink 81 is likely to crack upon punch or rupture of the printed circuit board.

To overcome the shortcomings, the present invention provides a cover layer with high thermal resistance and high reflectivity for a printed circuit board to mitigate or obviate the aforementioned problems.

The main objective of the present invention is to provide a cover layer with high thermal resistance and high reflectivity for a printed circuit board. The cover layer does not yellow under surface mount technology process, and thereby the cover layer maintains high reflectivity. Also, the cover layer has better structural strength; thereby, the cover layer is not prone to cracking.

The cover layer with high thermal resistance and high reflectivity for a printed circuit board has a polymer film, a reflective composite layer and an adhesive layer. The polymer film has a thickness ranging from 2 micro meters (µm) to 125 micro meters (µm), a melting point greater than 260°C and two side surfaces opposite to each other. The reflective composite layer is mounted on one of the side surfaces of the polymer film. The reflective composite layer has a thickness ranging from 2 µm to 30 µm and a first reflective pigment with a refractive index greater than 1. The adhesive layer is mounted on the other side surface of the polymer film. The adhesive layer has a thickness ranging from 10 µm to 75 µm. In addition, at a range of wavelength where a reflectivity of the cover layer is greater than 89%, absorption of the polymer film to the same range of wavelength is less than 35%.

In accordance with the present invention, "a cover layer with high thermal resistance" is designated to a cover layer that does not yellow and delaminate while undergoing surface mount technology process at a temperature ranging from 160°C to 320°C and for a time period ranging from 10 seconds to 180 seconds.

In accordance with the present invention, "a cover layer with high reflectivity" is designated to a cover layer that has a reflectivity ranging from 89% to 100% at a range of wavelength between 415 nanometers (nm) and 700 nanometers (nm).

Based on the above, by the first reflective pigment, reflectivity of the reflective composite layer to a light of an illumination element is raised and absorption of the reflective composite layer to the light of the illumination element is lowered. By the polymer film with absorption of 35% at the range of wavelength where reflectivity of the cover layer with high thermal resistance and high reflectivity for printed circuit board is greater than 89%, amount of absorption of a transmission light at the range of wavelength is reduced and the transmission light can be introduced to multiple reflections; thereby, luminous efficacy and color rendering index of an electronic product are enhanced without raising luminous intensity of the illumination element. Moreover, luminous efficacy and color rendering index of the electronic product can be enhanced with lowering luminous intensity of the illumination element. Since the melting point of the polymer film is greater than 260 °C, the cover layer with high thermal resistance and high reflectivity for a printed circuit board does not yellow and delaminate while undergoing treatment by surface mount technology process.

In addition, the reflective composite layer supports the polymer film, so the cover layer with high thermal resistance and high reflectivity for a printed circuit board is not prone to cracking upon punch or rupture of the printed circuit board.

Besides, as the thickness of the adhesive layer ranges from 10 µm to 75 µm, conductor spacing of a printed circuit board is filled and the circuit of a printed circuit board is covered.

In accordance with the present invention, thickness tolerance of the reflective composite layer is ±2 µm. Accordingly, the reflective composite layer is uniform in thickness; thereby the reflective composite layer reflects light uniformly.

In accordance with the present invention, the adhesive layer comprises a second reflective pigment and the polymer film comprises a third reflective pigment.

Preferably, the refractive index of the second reflective pigment is greater than 1 and the refractive index of the third reflective pigment is greater than 1.

Preferably, content of the first reflective pigment ranges from 20 volume percents (vol.%) to 70 volume percents (vol.%) based on the volume of the reflective composite layer. Content of the second reflective pigment ranges from 10 vol.% to 50 vol.% based on the volume of the adhesive layer. Content of the third reflective pigment ranges from 1 vol.% to 20 vol.% based on the volume of the polymer film.

Preferably, the first reflective pigment comprises a substance selected from a group consisting of: titanium dioxide, barium sulfate, strontium sulfate, aluminum oxide, zirconium dioxide, zinc oxide, magnesium oxide, calcium oxide, boron nitride, aluminum nitride, calcium carbonate, aluminum hydroxide and magnesium hydroxide.

Preferably, the second reflective pigment comprises a substance selected from a group consisting of: titanium dioxide, barium sulfate, strontium sulfate, aluminum oxide, zirconium dioxide, zinc oxide, magnesium oxide, calcium oxide, boron nitride, aluminum nitride, calcium carbonate, aluminum hydroxide and magnesium hydroxide.

Preferably, the third reflective pigment comprises a substance selected from a group consisting of: titanium dioxide, barium sulfate, strontium sulfate, aluminum oxide, zirconium dioxide, zinc oxide, magnesium oxide, calcium oxide, boron nitride, aluminum nitride, calcium carbonate, aluminum hydroxide and magnesium hydroxide.

In accordance with the present invention, the cover layer with high thermal resistance and high reflectivity for a printed circuit board is thin and thereby can be applied to compact products that are thin or slim.

Preferably, the thickness of the polymer film ranges from 6 µm to 25 µm. The thickness of the reflective composite layer ranges from 6 µm to 20 µm. The thickness of the adhesive layer ranges from 10 µm to 35 µm.

More preferably, the thickness of the polymer film ranges from 6 µm to 12 µm.

In accordance with the present invention, the reflective composite layer is made from a resin having a reactive functional group and a curing agent. The reactive functional group of the resin for making the reflective composite layer is selected from a group consisting of: carboxyl group, amine group, epoxy group, hydroxyl group and double bond. The curing agent for making the reflective composite layer is an aromatic or aliphatic compound having at least two functional groups. Each of functional groups of the curing agent for making the reflective composite layer is selected from a group consisting of: carboxyl group, anhydride group, amine group, hydroxyl group, epoxy group, isocyanate group and double bond.

In accordance with the present invention, the adhesive layer is made from a resin having a functional group and a curing agent. The functional group of the resin for making the adhesive layer is selected from a group consisting of: carboxyl group, amine group, epoxy group and hydroxyl group. The curing agent for making the adhesive layer is an aromatic or aliphatic compound having at least two functional groups. Each of the functional groups of the curing agent is selected from a group consisting of: carboxyl group, anhydride group, amine group, hydroxyl group, epoxy group and isocyanate group.

In accordance with the present invention, the polymer film is selected from a group consisting of: polyphenylene sulfide, polyethylene naphthalate and polyether ether ketone.

In accordance with the present invention, the cover layer with high thermal resistance and high reflectivity for a printed circuit board comprises a releasing layer mounted on a side surface of the adhesive layer that is opposite to the polymer film. The releasing layer is, but not limited to, releasing materials such as plastic releasing film and releasing paper.

In accordance with the present invention, the cover layer with high thermal resistance and high reflectivity for a printed circuit board is applicable to a rigid printed circuit board and a flexible printed circuit board.

Other objectives, advantages and novel features of the invention will become more apparent from the following detailed description when taken in conjunction with the accompanying drawings.

### IN THE DRAWINGS

Fig. 1 is an enlarged side view in cross section of a cover layer in accordance with the present invention.
Fig. 2 is an enlarged side view in cross section of Embodiments 1 to 11 of the cover layer of the present invention, shown attached on a printed circuit board for absorptivity measurement;
Fig. 3 is an enlarged side view in cross section of Embodiments 4 to 11 of the cover layer of the present invention, shown being laminated on a printed circuit board which mounted illumination elements by surface mount technology;
Fig. 4 shows reflectivity spectra of the cover layers of the present invention, wherein the symbol "■" represents Embodiment 4, the symbol "●" represents Embodiment 5, the symbol "▲" represents Embodiment 6 and the symbol "▼" represents Embodiment 7;
Fig. 5 shows absorptivity spectra of the polymer films of the present invention, wherein the symbol "●" represents the 50 µm thick PET film of Embodiment 8, the symbol "■" represents the 125 µm thick PET film of Embodiment 9, the symbol "◆" represents the 50 µm thick PPS film of Embodiment 10, the symbol "▲" represents the 12.5 µm thick polyimide films of Embodiments 4 to 6 and the symbol "▼" represents the 12.5 µm thick PEEK film of Embodiment 11;
Fig. 6 shows reflectivity spectra of the cover layers of the present invention, wherein the symbol "■" represents Embodiment 11 and the symbol "▲" represents Embodiment 6;
Fig. 7 shows reflectivity spectra of the cover layers of the present invention, wherein the symbol "■" represents Embodiment 10, the symbol "▲" represents Embodiment 8 and the symbol "●" represents Embodiment 9;
Fig. 8 is an enlarged side view in cross section of Comparison Example 1 of a printed circuit board having a reflective ink;
Fig. 9 shows reflectivity spectra of reflective inks in accordance with the present invention, wherein the symbol "▲" represents the reflective ink of Comparison Example 1 before the surface mount technology is performed, the symbol "▼" represents the reflective ink of Comparison Examplel after the surface mount technology is performed, the symbol "■" represents the reflective ink of Comparison Example 2 before the surface mount technology is performed and the symbol "●" represents the reflective ink of Comparison Example 2 after the surface mount technology is performed;
Fig. 10 is an enlarged side view in cross section of a printed circuit board having a reflective ink in accordance with the prior art.

### Embodiment 1

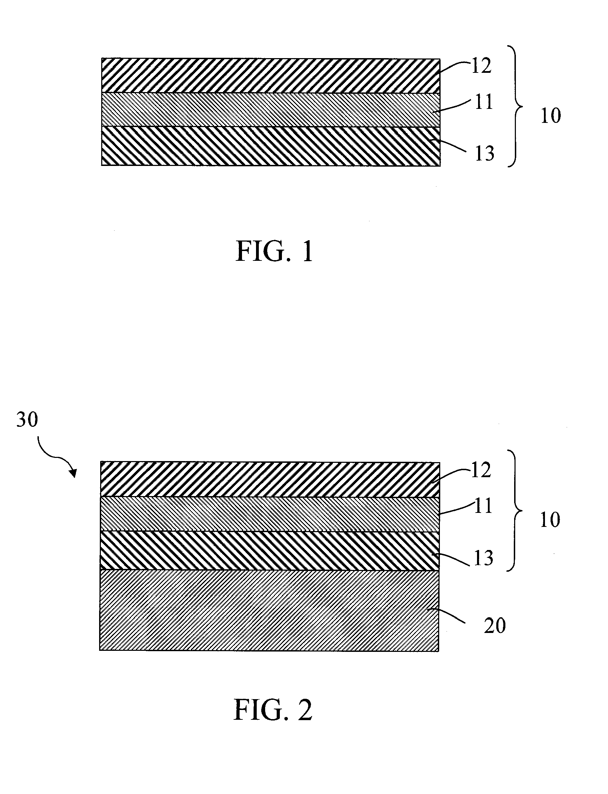

With reference to Fig. 1, a cover layer 10 with high thermal resistance and high reflectivity of a printed circuit board of the present embodiment comprised a polymer film 11, a reflective composite layer 12, an adhesive layer 13 and a releasing layer. The polymer film 11 had two side surfaces opposite to each other. The reflective composite layer 12 and the adhesive layer 13 were respectively mounted on the two side surfaces of the polymer film 11. The releasing layer was mounted on a side surface of the adhesive layer 13 that was opposite to the polymer film 11.

A method for making the cover layer 10 with high thermal resistance and high reflectivity for a printed circuit board of the present embodiment was as follows.

Firstly, the polymer film was provided.

Secondly, a first resin having functional groups, a first curing agent and a catalyst were mixed to from a first mixed solution. A first reflective pigment was dispersed in the first mixed solution by physical dispersion technology to form a composite solution. The composite solution was coated on a side surface of the polymer film 11 and cured between the first resin having a reactive functional group and the first curing agent to form reflective composite layer 12.

Thirdly, a second resin having a functional group and a second curing agent were mixed to from a second mixed solution. A second reflective pigment was dispersed in the second mixed solution by physical dispersion technology to form an adhesive solution. The adhesive solution was coated on a side surface of the polymer film 11 that was opposite to reflective composite layer 12 by coating and the adhesive layer 13 was obtained.

Finally, the releasing layer was mounted on a side surface of the adhesive layer 13 that was opposite to the polymer film 11.

In the present embodiment, the polymer film 11 was a polyimide film having a thickness of 12.5 µm, and the melting point of the polyimide film was greater than 260°C. The first resin having a functional group was a polyester-polyol copolymer having a hydroxy group. The first curing agent was polyisocyanate. The first reflective pigment was titanium dioxide (TiO₂) powder which had a refractive index greater than 1. The reflective composite layer 12 had a thickness of 20 µm. The content of titanium dioxide powder was 20 vol.% based on the volume of the reflective composite layer 12. The second resin having a functional group was an epoxy resin having an epoxy group. The second reflective pigment was calcium carbonate powder which had a refractive index greater than 1. The adhesive layer 13 had a thickness of 25µm; whereas a thickness tolerance of the adhesive layer 13 was ±2 µm. The content of calcium carbonate powder was 10 vol.% based on the volume of the adhesive layer 13. The releasing layer was a releasing paper.

With reference to Figs. 1 and 2, after the releasing layer was removed, the adhesive layer 13 of the cover layer 10 with high thermal resistance and high reflectivity was laminated on a surface of a printed circuit board 20. After heating, the adhesive layer 13 was cured and a specimen 30 for a reflectivity measurement was obtained.

In the present embodiment, Hitachi U-4100 spectrometer and a standard specimen was used in the reflectivity measurement. The standard specimen used was a barium sulfate standard piece manufactured by Hitachi. An incident light was reflected by the cover layer 10 to measure the reflectivity. The reflectivity of the cover layer 10 measured at a wavelength of 550 nm by the reflectivity measurement was shown in Table 1.

**Table 1 Measurement results of Embodiments 1 to 3.**

| Embodiment | 1 | 2 | 3 |
|---|---|---|---|
| Thickness of reflective composite layer | 20 µm | 20 µm | 20 µm |
| Thickness tolerance of reflective composite layer | ±2 µm | ±2 µm | ±2 µm |
| Kind of polymer film | Polyimide | Polyimide | Polyimide |
| Thickness of polymer film | 12.5 µm | 12.5 µm | 12.5 µm |
| Thickness of adhesive layer | 25 µm | 25 µm | 25 µm |
| Content of first reflective pigment based on the volume of reflective composite layer | 20 vol% | 30 vol% | 60 vol% |
| Reflectivity of cover layer (at a wavelength of 550 nm) | 89.0% | 90.2% | 90.5% |

### Embodiment 2

The present embodiment was similar to Embodiment 1. The differences between the present embodiment and Embodiment 1 was that the content of the titanium dioxide powder was 30 vol.% based on the volume of the reflective composite layer. The reflectivity measurement result of the present embodiment was shown in Table 1.

### Embodiment 3

The present embodiment was similar to Embodiment 1. The differences between the present embodiment and Embodiment 1 was that the content of the titanium dioxide powder was 60 vol.% based on the volume of the reflective composite layer. The reflectivity measurement result of the present embodiment was shown in Table 1.

### Embodiment 4

The present embodiment was similar to Embodiment 1. The differences between the present embodiment and Embodiment 1 were as follows.

With reference to Fig. 1, the reflective composite layer 12 of the cover layer 10 with high thermal resistance and high reflectivity for a printed circuit board had a thickness of 13 µm.

With reference to Figs. 1 and 2, after the releasing layer was removed, the adhesive layer 13 of the cover layer 10 with high thermal resistance and high reflectivity was laminated on a surface of a printed circuit board 20. After heating, the adhesive layer 13 was cured and a specimen 30 for a reflectivity measurement was obtained. In addition, The Hitachi U-4100 spectrometer was applied to measure reflectivity of the cover layer 10 and absorptivity of the polymer film 11.

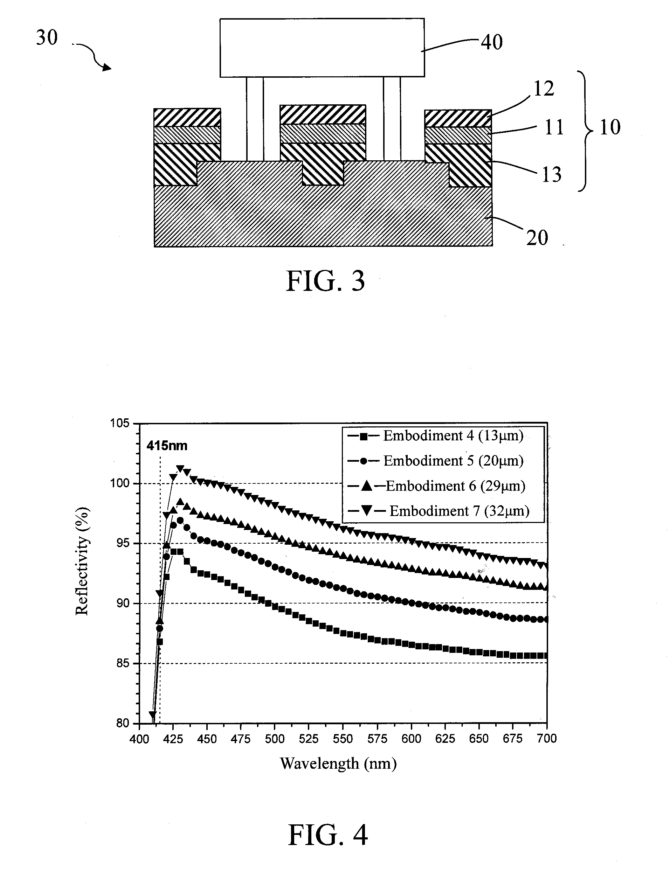

With reference to Fig. 3, surface mount technology was performed under 300 °C for 30 seconds to mount an illumination element 40 on the specimen 30. In detail, the illumination element 40 was mounted on the same side surface of the printed circuit board 20 as the adhesive layer 13. The surface mount technology was performed to measure thermal resistance and yellowing of the cover layer 10.

After surface mount technology was performed, yellowing of the cover layer 10 was measured. JIS-K7105 by Japanese Industrial Standard was applied to measure yellowing of the cover layer 10 after treatment by surface mount technology process. According to NBS Unit and color difference of CIE 1976 (Lab), a value of ΔE smaller than 1.5 was indicated as a slight color difference.

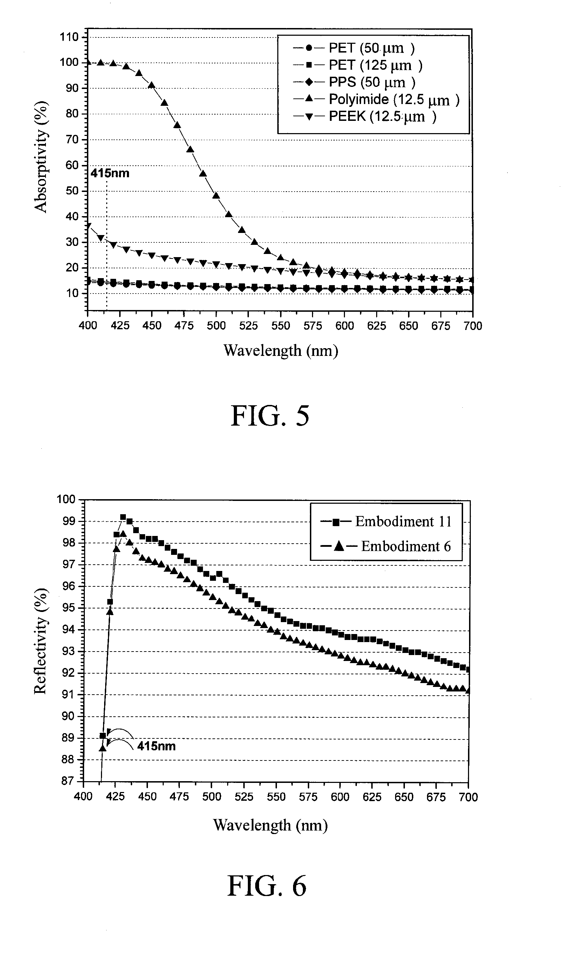

Measurement results of the present embodiment were shown in Table 2, Fig. 4 and Fig. 5.

### Embodiment 5

The present embodiment was similar to Embodiment 4. The difference between the present embodiment and Embodiment 4 was that the reflective composite layer had a thickness of 20 µm.

Measurement results of the present embodiment were shown in Table 2, Fig. 4 and Fig. 5.

### Embodiment 6

The present embodiment was similar to Embodiment 4. The difference between the present embodiment and Embodiment 4 was that the reflective composite layer had a thickness of 29 µm.

Measurement results of the present embodiment were shown in Table 2 and Figs. 4 to Fig. 6.

### Embodiment 7

The present embodiment was similar to Embodiment 4. The difference between the present embodiment and Embodiment 4 was that the reflective composite layer had a thickness of 32 µm.

Measurement results of the present embodiment were shown in Table 2, Fig. 4 and Fig. 5.

**Table 2 Measurement results of Embodiments 4 to 7.**

| Embodiment | 4 | 5 | 6 | 7 |
|---|---|---|---|---|
| Thickness of reflective composite layer | 13 µm | 20 µm | 29 µm | 32 µm |
| Thickness tolerance of reflective composite layer | ±2 µm | ±2 µm | +2 µm | +2 µm |
| Species of polymer film | Polyimide | Polyimide | Polyimide | Polyimide |
| Thickness of polymer film | 12.5µm | 12.5µm | 12.5µm | 12.5µm |
| Melting point of polymer film | greater than 260°C | greater than 260°C | greater than 260°C | greater than 260°C |
| Range of wavelength at which absorptivity of polymer film was less than 35% | 520 to 700 nm | 520 to 700 nm | 520 to 700 nm | 520 to 700 nm |
| Thickness of adhesive layer | 25 µm | 25 µm | 25 µm | 25 µm |
| Content of first reflective pigment based on the volume of reflective composite layer | 20 vol.% | 20 vol.% | 20 vol.% | 20 vol.% |
| Content of second reflective pigment based on the volume of adhesive layer | 10 vol.% | 10 vol.% | 10 vol.% | 10 vol.% |
| Range of wavelength at which reflectivity of cover layer was greater than 89% | 420 to 495 nm | 420 to 600 nm | 420 to 700 nm | 415 to 700 nm |
| Delamination of cover layer after surface mount technology (yes/no) | No | No | No | No |
| ΔE | 1.48 | 1.48 | 1.48 | 1.48 |

### Embodiment 8

The present embodiment was similar to Embodiment 4. The differences between the present embodiment and Embodiment 4 were: the polymer film was a polyethylene terephthalate (PET) film having a thickness of 50 µm; the reflective composite layer had a thickness of 29 µm.

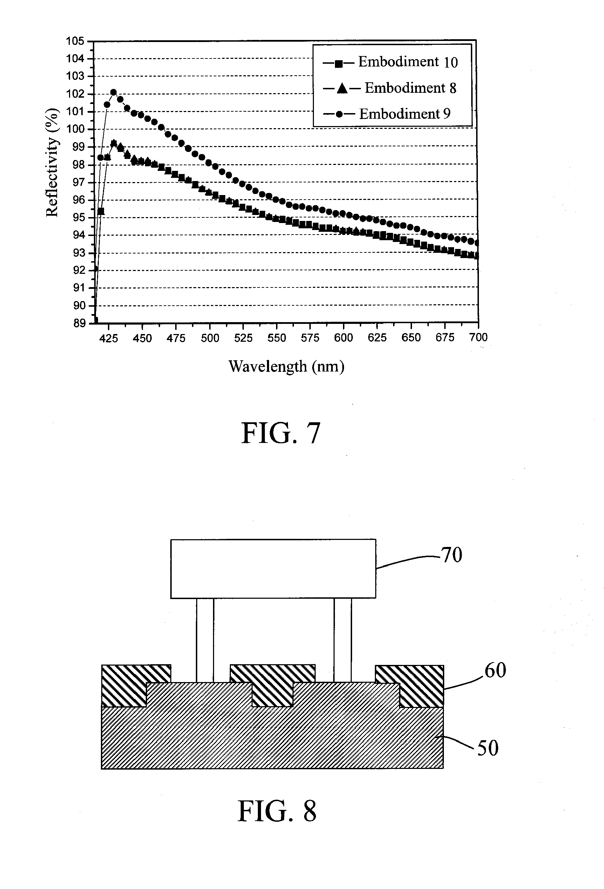

Measurement results of the present embodiment were shown in Table 3, Fig. 5 and Fig. 7.

### Embodiment 9

The present embodiment was similar to Embodiment 8. The difference between the present embodiment and Embodiment 8 was that the polymer film was a polyethylene terephthalate film having a thickness of 125 µm.

Measurement results of the present embodiment were shown in Table 3, Fig. 5 and Fig. 7.

**Table 3 Measurement results of Embodiments 8 and 9.**

| Embodiment | 8 | 9 |
|---|---|---|
| Thickness of reflective composite layer | 29µm | 29µm |
| Thickness tolerance of reflective composite layer | ±2µm | ±2µm |
| Species of polymer film | PET | PET |
| Thickness of polymer film | 50 µm | 125 µm |
| Melting point of polymer film | less than 260°C | less than 260°C |
| Range of wavelength at which absorptivity of polymer film was less than 35% | 330 to 700 nm | 330 to 700 nm |
| Thickness of adhesive layer | 25 µm | 25 µm |
| Content of first reflective pigment based on the volume of reflective composite layer | 20 vol.% | 20 vol.% |
| Content of second reflective pigment based on the volume of adhesive layer | 10 vol.% | 10 vol.% |
| Range of wavelength at which reflectivity of cover layer was greater than 89% | 415 to 700 nm | 415 to 700 nm |
| Delamination of cover layer after surface mount technology (yes/no) | Yes | Yes |
| ΔE | 1.48 | 1.48 |

### Embodiment 10

The present embodiment was similar to Embodiment 1. The differences between the present embodiment and Embodiment 1 were as follows.

The polymer film was a polyphenylene sulfide film having a thickness of 50 µm. The polyphenylene sulfide film had a melting point greater than 260°C. The reflective composite layer had a thickness of 29 µm. The second mixed solution served as the adhesive solution. The adhesive solution was coated on a side surface of the polymer film 11 by wet coating technology to obtain the adhesive layer; thereby, the content of the second reflective pigment was 0 vol.% based on the volume of the adhesive layer.

Also, the reflectivity of the cover layer was measured at a range of wavelength ranging from 400 nm to 700 nm. The reflectivity of the polyphenylene sulfide film was measured as well.

In addition, the surface mount technology of Embodiment 4 was performed to measure high thermal resistance of the cover layer in accordance with the present embodiment. Hitachi U-4100 spectrometer was applied to measure absorptivity of the polyphenylene sulfide (PPS) film.

Measurement results of the present embodiment were shown in Table 4, Fig. 5 and Fig. 7.

### Embodiment 11

The present embodiment was similar to Embodiment 10. The difference between the present embodiment and Embodiment 10 was that the polymer film was a polyether ether ketone (PEEK) film. The polyether ether ketone film had a melting point greater than 260°C.

Measurement results of the present embodiment were shown in Table 4, Fig. 5 and Fig. 6.

**Table 4 Measurement results of Embodiments 10 and 11.**

| Embodiment | 10 | 11 |
|---|---|---|
| Thickness of reflective composite layer | 29µm | 29µm |
| Thickness tolerance of reflective composite layer | ±2 µm | ±2 µm |
| Species of polymer film | PPS | PEEK |
| Thickness of polymer film | 50 µm | 12.5 µm |
| Melting point of polymer film | greater than 260°C | greater than 260°C |
| Range of wavelength at which absorptivity of polymer film was less than 35% | 340 to 700 nm | 390 to 700 nm |
| Thickness of adhesive layer | 25µm | 25µm |
| Content of first reflective pigment based on the volume of reflective composite layer | 20 vol.% | 20 vol.% |
| Content of second reflective pigment based on the volume of adhesive layer | 0 vol.% | 0 vol.% |
| Range of wavelength at which reflectivity of cover layer was greater than 89% | 415 to 700 nm | 415 to 700 nm |
| Delamination of cover layer after surface mount technology (yes/no) | No | No |
| ΔE | 1.48 | 1.48 |

### Comparison Example 1

With reference to Fig.8, a reflective ink 60 was printed on a surface of the printed circuit board 50 and a printed circuit board having a reflective ink was obtained. The reflective ink was T-75 manufactured by Teamchem. Materials Co.

In the present comparison example, the reflectivity measurement as Embodiment 1 was applied to measure the reflectivity of the reflective ink printed circuit board. Also, surface mount technology was performed under 288 °C for 10 seconds to measure high thermal resistance of the reflective ink. In detail, with reference to Fig. 8, an illumination element 70 was mounted on the same side surface of the printed circuit board 50 as the reflective ink 60. After the surface mount technology process was performed, the reflectivity measurement was applied to measure the reflectivity of the reflective ink again. In addition, the JIS-K7105 was applied to measure yellowing of the reflective ink 60 after the treatment by surface mount technology.

Measurement results of the present comparison example were shown in Table 5 and Fig. 9.

### Comparison Example 2

The present comparison embodiment was similar to Comparison Example 1. The difference between the present comparison embodiment and Comparison 1 was that the reflective ink was PSR-4000 series manufactured by Taiwan Taiyo Ink CO., LTD. Measurement results of the present comparison example were shown in Table 5 and Fig. 9.

**Table 5 Measurement results of Comparison Examples land 2.**

| Comparison Example | 1 | 2 |
|---|---|---|
| Thickness tolerance of reflective ink | +15µm | ±15µm |
| ΔE | 3.8 | 2.6 |

With reference to Fig. 9, before the surface mount technology was performed, the reflective ink of Comparison examples 1 and 2 each had a maximum reflectivity which was close to, but less than 80% at a range of wavelength ranging from 415 nm to 700 nm. After the surface mount technology was performed, the reflective inks of Comparison Examples 1 and 2 each had a maximum reflectivity less than 77% at the range of wavelength ranging from 415 nm to 700 nm. With reference to Table 5, after the surface mount technology was performed, the reflective inks of Comparison Examples 1 and 2 respectively had a ΔE value of 3.8 and a ΔE value of 2.6, both of which were greater than 1.5 were indicated as a slight color difference; thereby, the reflective inks of Comparison Examples 1 and 2 were both yellowing. Accordingly, after the surface mount technology was performed, the reflective inks of Comparison Examples 1 and 2 were both yellowing and thereby both had their own reflectivity decreased at the range of wavelength ranging from 415 nm to 700 nm.

With reference to Tables 1 to 5, Figs 4 to 7 and 9, at a wavelength of 550 nm, the cover layers of Embodiments 1 to 3 and 5 to 11 each had a reflectivity greater than 89% while the reflective inks of Comparison Examples 1 and 2 each had a reflectivity less than 80%; thereby, all of the cover layers of Embodiments 1 to 3 and 5 to 11 had a better reflectivity than the reflective inks of Comparison Examples 1 and 2. After the surface mount technology was performed, each of the cover layers of Embodiments 4 to 11 had a ΔE value of 1.48, which was smaller than 1.5; thereby, each of the cover layers of Embodiments 4 to 11 was not yellowing. Also, the reflective inks of Comparison Examples 1 and 2 both had a thickness tolerance of +15 µm while the reflective composite layers of Embodiments 1 to 11 each had a thickness tolerance of ±2 µm, indicating the reflective composite layers of Embodiments 1 to 11 were more uniform in thickness than the reflective inks of Comparison Examples 1 and 2.

With reference to Table 1, the reflective pigment content of the titanium dioxide powder of Embodiments 1 to 3 were respectively 20 vol%, 30 vol% and 60 vol% based on the volume of reflective composite layer. The cover layer of Embodiments 1 to 3 respectively had a reflectivity of 89%, 90.2% and 90.5% at a wavelength of 550 nm. Accordingly, as the content of the titanium dioxide powder was increased from 20 vol% to 60 vol% based on the volume of the reflective composite layer, the reflectivity of the cover layer was increased slightly from 89% to 90.2%. Thus, in order that the cover layer had a reflectivity of 89% or greater than 89%, the content of the titanium dioxide powder was at least 20% based on the volume of the reflective composite layer.

With reference to Table 2 and Fig. 4, the cover layer of Embodiment 4 had a reflectivity of or greater than 89% at a range of wavelength ranging from 420 nm to 495 nm; the cover layer of Embodiment 5 had a reflectivity greater than 89% at a range of wavelength ranging from 420 nm to 600 nm; the cover layer of Embodiment 6 had a reflectivity greater than 89% at a range of wavelength ranging from 420 nm to 700 nm; the cover layer of Embodiment 7 had a reflectivity greater than 89% at a range of wavelength ranging from 415 nm to 700 nm. The reflective composite layers of Embodiments 4 to 7 respectively had a thickness of 13 µm, 20 µm, 29 µm and 32 µm. Each of the polymer films of Embodiments 4 to 7 was a polyimide film with a thickness of 12.5 µm. With reference to Fig. 5, a polyimide film with a thickness of 12.5 µm had an absorptivity greater than 35% at a range of wavelength ranging from 415 nm to 520 nm. Therefore, for a cover layer having a polyimide film with a thickness of 12.5 µm, to have a reflectivity greater than 89% at a range of wavelength ranging from 420 nm to 495 nm, the cover layer shall have a reflective composite layer with a thickness greater than 30 µm. Also, for a cover layer having a reflective composite layer with a thickness equal to or less than 30 µm, to have a reflectivity greater than 89% at a range of wavelength ranging from 415 nm to 700 nm, the cover layer shall have a polymer film with an absorptivity less than 35%.

With reference to Table 3, Fig. 5 and Fig. 7, the polymer film of Embodiment 8 had a thickness of 50 µm and the polymer film of Embodiment 9 had a thickness of 125 µm. In addition, at a range of wavelength ranging from 330 nm to 700 nm, the polymer films of Embodiments 8 and 9 both had an absorptivity less than 35% and the cover layers of Embodiments 8 and 9 both had a reflectivity greater than 89%. Thus, between Embodiments 8 and 9, the thickness difference of the polymer films had no influence on the reflectivity of the cover layers.

With reference to Table 3, Table 4 and Fig. 5, the polymer film of Embodiment 8 was a polyethylene terephthalate film having a thickness of 50 µm and the polymer film of Embodiment 10 was a polyphenylene sulfide film having a thickness of 50 µm, both of which had an absorptivity less than 35%. With reference to Fig. 7 and Table 3, the cover layer of Embodiments 8 and 10 both had a reflectivity greater than 89%. After the surface mount technology was performed, delamination of the cover layer of Embodiment 8 was found between the reflective composite layer and the polyethylene terephthalate film, between the polyethylene terephthalate film and the adhesive layer, and between the adhesive layer and the printed circuit board while there was no delamination of the cover layer of Embodiment 10. After comparing the cover layer of Embodiment 8 with the cover layer of Embodiment 10, the difference between them was that the polyethylene terephthalate film had a melting point less than 260°C and the polyphenylene sulfide film had a melting point greater than 260°C. Thus, after the surface mount technology was performed on a cover layer having a polymer film with a melting point greater than 260°C, there was no delamination of the cover.

With reference to Tables 2 and 4, the polymer film of Embodiment 6 was a polyimide film with a thickness of 12.5 µm and a melting point greater than 260°C; the polymer film of Embodiment 11 was a polyether ether ketone film with a thickness of 12.5 µm and a melting point greater than 260°C. After the surface mount technology was performed, each of the cover layers of Embodiments 6 and 11 was found not delaminated. However, with reference to Table 2, Fig. 5 and Fig. 6, the polymer film of Embodiment 6 had an absorptivity greater than 35% at a range of wavelength ranging from 415 nm to 520 nm; the cover layer of Embodiment 6 had a reflectivity less than 89% at a range of wavelength between 415 nm to 420 nm; thereby, at a range of wavelength ranging from 415 nm to 700 nm, reflectivity of the cover layer of Embodiment 6 was not always greater than 89%. With reference to Table 4, Fig. 5 and Fig. 6, at a range of wavelength ranging from 415 nm to 700 nm, the polymer film of Embodiment 11 had an absorptivity less than 35% and the cover layer of Embodiment 11 had a reflectivity greater than 89%.

With reference to Tables 1 to 4, the adhesive layers of Embodiments 1 to 8 each had a second reflective pigment of 10 vol% while the adhesive layers of Embodiments 10 and 11 did not. At a wavelength of 550 nm, each of the cover layers of Embodiments 1 to 3 and 5 to 8 had a reflectivity greater than 89%; both of the cover layers of Embodiments 10 and 11 had a reflectivity greater than 89%; thereby, each of the cover layers of Embodiments 1 to 3 and 5 to 8 had a reflectivity pretty close to the cover layers of Embodiments 10 and 11.

Based on the above, the cover layers of Embodiments 1 to 7, 10 and 11 all had a higher reflectivity and lower yellowing after surface mount technology process than the reflective inks of Comparison Examples 1 and 2. According to Embodiments 10 to 11, by using the polymer film, which had a melting point greater than 260°C and an absorptivity less than 35% at a range of wavelength ranging from 415 nm to 700 nm, and the reflective composite layer having the first reflective pigment, the cover layer in accordance with the present invention had a reflectivity greater than 89% at a range of wavelength ranging from 415 nm to 700 nm and would not yellow and be delaminated under the surface mounted technology process (300°C/30 seconds); thereby, luminous efficacy and color rendering index of an electronic product would be enhanced without raising power of the illumination element. Moreover, luminous efficacy and color rendering index of the electronic product could be enhanced with lowering power of the illumination element.

Even though numerous characteristics and advantages of the present invention have been set forth in the foregoing description, together with details of the structure and features of the invention, the disclosure is illustrative only. Changes may be made in the details, especially in matters of shape, size, and arrangement of parts within the principles of the invention to the full extent indicated by the broad general meaning of the terms in which the appended claims are expressed.

## Claims

1. A cover layer (10) with high thermal resistance and high reflectivity for a printed circuit board, the cover layer (10) having:
a polymer film (11) having
a thickness ranging from 2 µm to 125 µm;
a melting point greater than 260°C; and
two side surfaces opposite to each other;
a reflective composite layer (12) mounted on one of the side surfaces of the polymer film (11) and having
a thickness ranging from 2 µm to 30 µm; and
a first reflective pigment with a refractive index greater than 1; and
an adhesive layer (13) mounted on the other side surface of the polymer film (11) and having
a thickness ranging from 10 µm to 75 µm;
wherein at a range of wavelength where reflectivity of the cover layer (10) of the printed circuit board is greater than 89%, absorption of the polymer film (11) is less than 35%.

2. The cover layer (10) as claimed in claim 1, wherein the adhesive layer (13) has
a second reflective pigment.

3. The cover layer (10) as claimed in claim 2, wherein the second reflective pigment has
a refractive index greater than 1.

4. The cover layer (10) as claimed in claim 1, wherein the polymer film (11) has
a third reflective pigment.

5. The cover layer (10) as claimed in claim 4, wherein the third reflective pigment has
a refractive index greater than 1.

6. The cover layer (10) as claimed in claim 1, wherein a content of the first reflective pigment ranges from 20 vol.% to 70 vol.% based on a volume of the reflective composite layer (12).

7. The cover layer (10) as claimed in claim 2, wherein a content of the second reflective pigment ranges from 10 vol% to 50 vol% based on a volume of the adhesive layer (13).

8. The cover layer (10) as claimed in claim 4, wherein a content of the third reflective pigment ranges from 1 vol% to 20 vol% based on a volume of the polymer film (11).

9. The cover layer (10) as claimed in claim 1, wherein the thickness of the polymer film (11) ranges from 12.5 µm to 125 µm.

10. The cover layer (10) as claimed in claim 1, wherein the thickness of the reflective composite layer (12) ranges from 6 µm to 20 µm.

11. The cover layer (10) as claimed in claim 1, wherein the thickness of the adhesive layer (13) ranges from 10 µm to 35 µm.

12. The cover layer (10) as claimed in claim 1, wherein the reflective composite layer (12) is made from
a resin having a functional group selected from a group consisting of: carboxyl group, amine group, epoxy group, hydroxyl group and double bond; and
a curing agent which is an aromatic or aliphatic compound having at least two functional groups, wherein each of the functional groups of the curing agent is selected from a group consisting of: carboxyl group, anhydride group, amine group, hydroxyl group, epoxy group, isocyanate group and double bond.

13. The cover layer (10) as claimed in claim 1, wherein the adhesive layer (13) is made from
a resin having a functional group selected from a group consisting of: carboxyl group, amine group, epoxy group and hydroxyl group; and
a curing agent which is an aromatic or aliphatic compound having at least two functional groups, wherein each of the functional groups of the curing agent is selected from a group consisting of: carboxyl group, anhydride group, amine group, hydroxyl group, epoxy group and isocyanate group.

14. The cover layer (10) as claimed in claim 1, wherein the polymer film (11) is selected from a group consisting of: polyphenylene sulfide, polyethylene naphthalate and polyether ether ketone.

15. The cover layer (10) as claimed in claim 1, wherein the range of wavelength at which reflectivity of the cover layer (10) is greater than 89% and the absorption of the polymer film (11) is less than 35% ranges from 415 nm to 700 nm.

## Amended claims

### Amended claims in accordance with Rule 137(2) EPC.

1. A cover layer (10) with high thermal resistance and high reflectivity for a printed circuit board, the cover layer (10) having:
a polymer film (11) having
a thickness ranging from 2 µm to 125 µm;
a melting point greater than 260°C; and
two side surfaces opposite to each other;
a reflective composite layer (12) mounted on one of the side surfaces of the polymer film (11) and having
a thickness ranging from 2 µm to 30 µm; and
a first reflective pigment with a refractive index greater than 1; and
an adhesive layer (13) mounted on the other side surface of the polymer film (11) and having
a thickness ranging from 10 µm to 75 µm;
wherein from wavelength 415 nm to 700 nm, the reflectivity of the cover layer (10) of the printed circuit board is greater than 89% and the absorptivity of the polymer film (11) is less than 35%.

2. The cover layer (10) as claimed in claim 1,
wherein the adhesive layer (13) has
a second reflective pigment.

3. The cover layer (10) as claimed in claim 2,
wherein the second reflective pigment has
a refractive index greater than 1.

4. The cover layer (10) as claimed in claim 1,
wherein the polymer film (11) has
a third reflective pigment.

5. The cover layer (10) as claimed in claim 4,
wherein the third reflective pigment has
a refractive index greater than 1.

6. The cover layer (10) as claimed in claim 1,
wherein a content of the first reflective pigment ranges from 20 vol.% to 70 vol.% based on a volume of the reflective composite layer (12).

7. The cover layer (10) as claimed in claim 2,
wherein a content of the second reflective pigment ranges from 10 vol% to 50 vol% based on a volume of the adhesive layer (13).

8. The cover layer (10) as claimed in claim 4,
wherein a content of the third reflective pigment ranges from 1 vol% to 20 vol% based on a volume of the polymer film (11).

9. The cover layer (10) as claimed in claim 1,
wherein the thickness of the polymer film (11) ranges from 12.5 µm to 125 µm.

10. The cover layer (10) as claimed in claim 1,
wherein the thickness of the reflective composite layer (12) ranges from 6 µm to 20 µm.

11. The cover layer (10) as claimed in claim 1,
wherein the thickness of the adhesive layer (13) ranges from 10 µm to 35 µm.

12. The cover layer (10) as claimed in claim 1,
wherein the reflective composite layer (12) is made from
a resin having a functional group selected from a group consisting of: carboxyl group, amine group, epoxy group, hydroxyl group and double bond; and
a curing agent which is an aromatic or aliphatic compound having at least two functional groups, wherein each of the functional groups of the curing agent is selected from a group consisting of: carboxyl group, anhydride group, amine group, hydroxyl group, epoxy group, isocyanate group and double bond.

13. The cover layer (10) as claimed in claim 1,
wherein the adhesive layer (13) is made from
a resin having a functional group selected from a group consisting of: carboxyl group, amine group, epoxy group and hydroxyl group; and
a curing agent which is an aromatic or aliphatic compound having at least two functional groups, wherein each of the functional groups of the curing agent is selected from a group consisting of: carboxyl group, anhydride group, amine group, hydroxyl group, epoxy group and isocyanate group.

14. The cover layer (10) as claimed in claim 1,
wherein the polymer film (11) is selected from a group consisting of: polyphenylene sulfide, polyethylene naphthalate and polyether ether ketone.
